# EUROPÄISCHE PATENTSCHRIFT

(11) **EP 0 492 253 B1**
(45) Veröffentlichungstag und Bekanntmachung des Hinweises auf die Patenterteilung: **23.04.1997**
(21) Anmeldenummer: 91121084.7
(22) Anmeldetag: 09.12.1991
(51) Int. Cl.: G03F 7/40, G03F 7/039

(54) **Photostrukturierungsverfahren**
Photolithographic process
Procédé photolithographique

(30) Priorität: 20.12.1990 DE 4040998
(43) Veröffentlichungstag der Anmeldung: 01.07.1992
(73) Patentinhaber: SIEMENS AKTIENGESELLSCHAFT, 80333 München (DE)
(72) Erfinder: Sebald, Michael, Dr., W-8521 Hessdorf-Hanndorf (DE); Beck, Jürgen, Dipl.-Chem., W-8520 Erlangen (DE); Leuschner, Rainer, Dr., W-8520 Erlangen (DE); Sezi, Recai, Dr., W-8551 Röttenbach (DE); Birkle, Siegfried, Dr., W-8552 Höchstadt (DE); Ahne, Hellmut, Dr., W-8551 Röttenbach (DE); Kühn, Eberhard, W-8551 Hemhofen (DE)

(56) Entgegenhaltungen:
- EP-A- 0 102 450
- EP-A- 0 234 327
- EP-A- 0 395 917

## Beschreibung

Die Erfindung betrifft ein Verfahren zur Strukturerzeugung im Submikron-Bereich.

Aus der EP-OS 0 388 484 ist ein wäßrig-alkalisch entwickelbarer, hochauflösender Photoresist zur Strukturerzeugung im Submikron-Bereich bekannt. Dieser Resist besteht aus einem entwikkelbaren Basispolymer und einer photoaktiven Komponente (sowie gegebenenfalls weiteren üblichen Zusätzen), wobei das Basispolymer als entwickelbare - und somit lösungsvermittelnde - Gruppen Anhydridfunktionen aufweist. Die anhydridhaltigen Basispolymere, die DUV-transparent sind und sich sowohl für die Einlagen- als auch für die Zweilagentechnik eignen, enthalten vorzugsweise 10 bis 55 Mol-% Maleinsäureanhydrid und werden durch Co- bzw. Terpolymerisation mit Allyltrimethylsilan und Styrol sowie gegebenenfalls mit einem weiteren Monomer, beispielsweise Maleinimid, erhalten.

Photoresists mit derartigen Basispolymeren, die als photoaktive Komponente Diazonaphthochinon- oder Diazoketonderivate aufweisen, benötigen bei DUV-Belichtung, beispielsweise bei einer Wellenlänge von 248 nm, für eine maßhaltige Belichtung eine Dosis von etwa 70 bis 80 mJ/cm². Diese relativ hohe Dosis kann von Nachteil sein, weil bei Fertigungslinien, beispielsweise für hochintegrierte mikroelektronische Bauelemente, bei einem geringen Durchsatz eine lange Belegung der kostenintensiven Belichtungsgeräte (Stepper) erforderlich ist; in der Fertigung wird deshalb im allgemeinen eine Empfindlichkeit < 20 mJ/cm² gefordert. Bei der Verwendung von siliciumhaltigen Resists der genannten Art in der Zweilagentechnik ergibt sich noch das Problem, daß nach der Strukturübertragung im Sauerstoffplasma im Bottomresist Submikron-Strukturen erhalten werden, die gegenüber den Strukturen im Topresist mehr als 10 % an Maß verloren haben; dies ist für die Fertigung aber nicht tolerierbar.

Aus der EP-OS 0 395 917 ist ein Photostrukturierungsverfahren bekannt, welches die photolithographische Übertragung von Submikron-Strukturen in der Zweilagentechnik erlaubt. Bei diesem Verfahren werden die Vorteile von anhydridhaltigen Basispolymeren bzw. Resists genutzt, und gleichzeitig wird eine maßhaltige Übertragung ermöglicht, d.h. es wird bei der Zweilagentechnik im Bottomresist das exakte Maskenmaß reproduziert. Dies geschieht durch eine chemische Aufweitung der anhydridhaltigen Strukturen im Topresist in einem Ausmaß, das genau dem Maßverlust entspricht, der bei der Strukturübertragung im Sauerstoffplasma auftritt. Auch bei diesem Verfahren ist aber zur Strukturierung des Topresists eine relativ hohe Dosis erforderlich, nämlich etwa 90 mJ/cm² (im DUV-Bereich).

Durch das genannte Photostrukturierungsverfahren wurde ferner erstmals die Möglichkeit eröffnet, Strukturdimensionen zu erzeugen, die kleiner sind als es durch die physikalische Auflösungsgrenze der angewendeten Lithographietechnik vorgegeben wird, d.h. es wird in der Photoresiststruktur die Grabenbreite bis unter die Auflösungsgrenze verkleinert. Dies erfolgt durch eine chemische Aufweitung der anhydridhaltigen Resiststrukturen um ein Maß von einigen Nanometern bis zu einigen Mikrometern, womit eine entsprechende Grabenverengung einhergeht. Bei dieser Vorgehensweise, die sowohl bei der Einlagen- als auch bei der Zweilagentechnik möglich ist, werden Resists mit Diazoketonderivaten als photoaktive Komponente eingesetzt, diese Resists genügen aber den Fertigungsansprüchen hinsichtlich der Empfindlichkeit nicht.

Aus der EP-OS 0 102 450 (bzw. der entsprechenden US-Patentschrift 4 491 628) ist eine positiv oder negativ arbeitende Resistzusammensetzung bekannt, bei der das Problem der ungenügenden Empfindlichkeit herkömmlicher Resists mit dem Konzept der sogenannten chemischen Verstärkung angegangen wird. Die Resistzusammensetzung weist dazu ein Polymer mit säurelabilen Resten und einen Photoinitiator auf, der bei Belichtung eine Säure freisetzt. Dabei werden Basispolymere verwendet, die alkalilösliche Gruppen, beispielsweise phenolische OH-Gruppen (in einem Vinylphenol-Polymer), besitzen, welche durch säurespaltbare Gruppen, beispielsweise eine tert.-Butyl- oder tert.-Butoxycarbonylgruppe, blockiert sind; das Polymer ist somit zunächst kaliunlöslich. Als Photoinitiator (bzw. Photosäure), der bei Belichtung mit DUV-Licht, Elektronen- oder Röntgenstrahlen eine starke Säure bildet, dienen sogenannte Crivellosalze, d.h. Oniumsalze, wie Triphenylsulfonium-hexafluorophosphat.

Die hohe Empfindlichkeit von Resistzusammensetzungen der vorstehend genannten Art erklärt sich daraus, daß bei einer auf die Belichtung folgenden Temperaturbehandlung ("post exposure bake") ein einziges Proton, welches bei der Belichtung aus der Photosäure erzeugt wurde, und zwar durch ein Photon, katalytisch eine Vielzahl der säurespaltbaren Gruppen abspaltet, d.h. eine Vielzahl von alkalilöslichen Gruppen freisetzt. Bei herkömmlichen Resists mit Diazoverbindungen (als photoaktive Komponente) kann dagegen pro Photon maximal nur eine einzige alkalilösliche Säuregruppierung erzeugt werden. Für die genannten Resistzusammensetzungen wird eine Empfindlichkeit angegeben, die bei UV-Belichtung von 5 bis 55 mJ/cm² reicht bzw. bei tronenstrahlbelichtung bei 10 µC/cm² liegt; außerdem zeigen sie einen hohen Kontrast. Von Nachteil ist bei diesen Systemen aber, daß eine maßhaltige Strukturübertragung nicht möglich ist, daß keine engen Gräben erzeugt werden können, d.h. Gräben mit einer Breite kleiner als die Auflösungsgrenze, und daß entweder die DUV-Transparenz oder die Ätzresistenz gegen Substratätzprozesse relativ gering ist.

Aus der EP-OS 0 234 327 (bzw. den entsprechenden US-Patentschriften 4 837 124 und 4 912 018) ist eine Photoresistzusammensetzung für DUV- und Excimerlaser-Lithographie bekannt, welche ebenfalls nach dem Konzept der chemischen Verstärkung arbeitet. Die Resistzusammensetzung weist dazu 1 bis 50 % einer latenten Photosäure und 50 bis 99 % eines filmbildenden, Imidgruppen enthaltenden Polymers auf, zusammen gelöst in einem Lösungsmittel. Dabei ist eine genügende Anzahl der Imidgruppen mit säurelabilen Gruppen blockiert, um das Polymer alkaliunlöslich zu machen; derartige Gruppen sind Oxycarbonylgruppen, insbesondere die tert.-Butoxycarbonylgruppe. Die säurelabilen Gruppen werden mittels der Photosäure - in der beschriebenen Weise - abgespalten, wodurch das Polymer - aufgrund der dabei entstehenden Imidgruppen - alkalilöslich wird. Der Vorteil dieser Resistzusammensetzung ist ein verbessertes Auflösungsvermögen, sie weist aber dieselben Nachteile auf wie die sistzusammensetzung nach der EP-OS 0 102 450. Außerdem ist von Nachteil, daß die Einführung der säurelabilen Gruppen mittels einer polymeranalogen Reaktion nicht steuerbar ist und nicht reproduzierbar verläuft und damit auch nicht quantitativ erfolgt.

Aufgabe der Erfindung ist es, ein Verfahren anzugeben, das eine maßhaltige Strukturübertragung in der Zweilagentechnik und die Erzeugung von Strukturen (Gräben bzw. Löcher) jenseits der Auflösungsgrenze erlaubt, wobei eine hohe Transparenz, ein hohes Auflösungsvermögen, auch im Subhalbmikron-Bereich, und eine hohe Empfindlichkeit (< 20 mJ/cm² im DUV-Bereich) gegeben sein soll, und zwar sowohl für UV-Licht als auch für Elektronen- und Röntgenstrahlen.

Dies wird erfindungsgemäß dadurch erreicht, daß
a) auf ein Substrat eine Photoresistschicht aus einer Polymerkomponente mit
   - funktionellen Gruppen, die zu einer Reaktion mit primären oder sekundären Aminen befähigt sind, und
   - N-blockierten Imidgruppen,
   einem bei Belichtung eine Säure freisetzenden Photoinitiator und einem geeigneten Lösungsmittel aufgebracht wird,
b) die Photoresistschicht getrocknet wird,
c) die Photoresistschicht bildmäßig belichtet wird,
d) die belichtete Photoresistschicht einer Temperaturbehandlung unterworfen wird,
e) die derart behandelte Photoresistschicht mit einem wäßrigalkalischen oder organischen Entwickler zu einer Photoresiststruktur entwickelt wird und
f) die Photoresiststruktur - zur Aufweitung der Resistlinien und zur Erzeugung von Ätzresistenz - mit einem ein primäres oder sekundäres Amin enthaltenden chemischen Agens behandelt wird,
wobei bei der Entwicklung ein definierter Dunkelabtrag im Bereich zwischen 20 und 100 nm eingestellt wird.

Beim erfindungsgemäßen Verfahren ist wesentlich, daß ein Photoresist mit einer Polymerkomponente eingesetzt wird, die zwei verschiedene Arten von funktionellen Gruppen aufweist. Dies sind einerseits Gruppen, die mit primären und sekundären Aminen reagieren, und andererseits N-blockierte Imidgruppen. Bei letzteren teren handelt es sich um NH-Gruppen (von Säureimiden), bei das Wasserstoffatom durch eine säurespaltbare Schutzgruppe ersetzt ist. Die beiden funktionellen Gruppen können dabei in verschiedenen Polymeren vorhanden sein, vorteilhaft liegen sie jedoch in ein und demselben Polymer vor.

Beim Verfahren nach der Erfindung ist ferner wesentlich, daß - bei der Entwicklung - ein definierter Dunkelabtrag erfolgt. Dieser Dunkelabtrag liegt im Bereich zwischen 20 und 100 nm; vorzugsweise beträgt der Dunkelabtrag ca. 50 nm.

Zur Einstellung des Dunkelabtrags stehen drei Möglichkeiten zur Verfügung, die einzeln oder zusammen zur Anwendung gelangen können:
- Die Temperatur/Zeit-Kombination bei der Trocknung des Photoresists (Verfahrensschritt b);
- die Temperatur/Zeit-Kombination bei der Temperaturbehandlung des Photoresists (Verfahrensschritt d);
- Temperatur und Dauer der Entwicklung sowie die Art und gegebenenfalls die Konzentration des Entwicklers (Verfahrensschritt e).

Bei den beiden erstgenannten Möglichkeiten wird die Temperatur/Zeit-Kombination beim Erwärmen des Resists, beispielsweise auf einer Hotplate, so gewählt, daß sich bei der Naßentwicklung der gewünschte Dunkelabtrag einstellt. In beiden Fällen, d.h. bei der Resisttrocknung ("prebake") und bei der Temperaturbehandlung ("post exposure bake"), wird die Erwärmung vorzugsweise im Temperaturbereich zwischen 60 und 160°C durchgeführt, vorzugsweise in einem Zeitraum zwischen 10 und 150 s; dabei erfolgt eine thermische Abspaltung von Schutzgruppen. Die Naßentwicklung erfolgt im allgemeinen bei einer Temperatur von 5 bis 50°C, und zwar für die Dauer von 15 bis 300 s; die Konzentration des wäßrig-alkalischen Entwicklers, beispielsweise eines tetramethylammoniumhydroxidhaltigen Entwicklers, ist dabei 0,05 bis 1 molar.

Das Verfahren nach der Erfindung kann - in der vorstehend beschriebenen Weise - nach der Einlagenresisttechnik verlaufen; dabei muß der eingesetzte Photoresist, der für die Belichtungswellenlänge transparent ist, nicht notwendigerweise resistent gegen Substratätzprozesse sein. Vorteilhaft kann dieses Verfahren jedoch auch nach der Zweilagenresisttechnik arbeiten. Dazu wird auf das Substrat zunächst eine Schicht aus einem gegen Substratätzprozesse resistenten Resist aufgebracht. Dieser Resist, der sogenannte Bottomresist, weist deshalb aromatische Strukturen auf; üblicherweise dient hierzu ein Novolak. Anschließend wird der Bottomresist ausgeheizt; hierbei erfolgt eine Quervernetzung (des Novolaks), wodurch der Resist für Topresist-Lösungsmittel unlöslich wird.

Auf den Bottomresist wird dann, entsprechend dem erfindungsgemäßen Verfahren, ein Photoresist - als Topresist - aufgebracht; dieser Resist muß nicht notwendigerweise ätzresistent gegen eine Trockenentwicklung im Sauerstoffplasma sein. Der Topresist wird - in der beschriebenen Weise - getrocknet, belichtet, einer Temperaturbehandlung unterworfen, naß entwickelt und chemisch nachbehandelt. Die nach der chemischen Nachbehandlung vorliegende Photoresiststruktur wird dann noch in einem anisotropen sauerstoffhaltigen Plasma geätzt, wodurch eine Strukturübertragung in den Bottomresist erfolgt.

Bei der bildmäßigen Belichtung (Schritt c) wird beim erfindungsgemäßen Verfahren - in den belichteten Bereichen - aus dem Photoinitiator eine Säure erzeugt. Durch die auf die Belichtung folgende Temperaturbehandlung ("post exposure bake") erfolgt dann eine säurekatalysierte Abspaltung der Schutzgruppen. Dabei wird das zunächst alkaliunlösliche Polymer alkalilöslich, d.h. der Resist wird in den belichteten Bereichen entwickelbar. Durch die auf die alkalische Entwicklung folgende chemische Nachbehandlung werden die (Top-)Resistlinien aufgeweitet, d.h. die (Top-)Resistgräben bzw. -löcher werden verengt. Bei der Einlagentechnik wird gleichzeitig - durch die Verwendung eines aromatenhaltigen Agens - eine Ätzresistenz gegen Substratätzprozesse erzeugt, während bei der Zweilagentechnik - durch die Verwendung eines siliciumhaltigen Agens - eine Ätzresistenz gegen Trockenentwicklung im Sauerstoffplasma bewirkt wird.

Die funktionellen Gruppen der Polymerkomponente, die mit primären und sekundären Aminen reagieren können, sind vorzugsweise Carbonsäureanhydridgruppen; daneben kommen insbesondere auch Epoxidgruppen und Estergruppen in Betracht. Den Anhydridgruppen liegt vorzugsweise Maleinsäureanhydrid zugrunde, gegebenenfalls in substituierter Form; eine andere Verbindung dieser Art ist beispielsweise Itaconsäureanhydrid (Itaconsäure = Methylenbernsteinsäure). Die Polymere können sowohl cyclische Anhydridfunktionen aufweisen, wobei diese entweder in der Haupt- oder in der Seitenkette angeordnet sein können, als auch nicht-cyclische, d.h. lineare Anhydridfunktionen. Eine Reihe von entsprechenden Monomeren sind aus der EP-OS 0 388 484 bekannt, spielsweise Acryl- bzw. Methacrylsäureanhydrid und Vinylphthalsäureanhydrid.

Die Imidgruppen der Polymerkomponente sind vorzugsweise mit einem tert.-Butoxycarbonylrest, d.h. -CO-O-C(CH₃)₃ (Boc-Rest), und/oder einem tert.-Butylrest blockiert. Diese als eine Art Schutzgruppe dienenden Reste sind säurelabil, d.h. sie werden durch Säuren abgespalten. Den Imidgruppen liegt vorzugsweise Maleinimid zugrunde, gegebenenfalls in substituierter Form. Eine andere mögliche Imidgruppe kann im Polymer beispielsweise in Form von Glutarimideinheiten vorliegen. Ein Verfahren zur Herstellung von Boc-blockiertem Maleinimid ist Gegenstand der deutschen Patentanmeldung Akt.Z. P 40 40 999.6 (GR 90 P 8599 DE) - "N-tert.-Butoxycarbonyl-maleinimid".

Als Comonomere für eine Polymerisation mit N-tert.-Butoxycarbonyl- bzw. N-tert.-Butyl-maleinimid - zur Herstellung der Polymerkomponente - können Verbindungen verwendet werden, wie sie aus der EP-OS 0 388 484 bekannt sind; die Polymerisation wird dabei vorzugsweise radikalisch initiiert. Die Polymere zeichnen sich durch eine hohe Transparenz sowohl im nahen als auch im tiefen UV-Bereich aus und eignen sich daher in hervorragender Weise für die Verwendung in Hochkontrast-DUV-Photoresists, beispielsweise für Belichtungen mit KrF-Excimerlaser-Belichtungsgeräten (bei einer Wellenlänge von 248 nm).

Vorteilhaft können beim erfindungsgemäßen Verfahren beispielsweise N-tert.-Butoxycarbonyl- bzw. N-tert.-Butyl-maleinimid/Maleinsäureanhydrid-Copolymere Verwendung finden. Vorzugsweise gelangen jedoch Copolymere aus N-tert.-Butoxycarbonyl- bzw. N-tert.-Butyl-maleinimid, Maleinsäureanhydrid und Styrol und/oder Allyltrimethylsilan zum Einsatz. N-tert.-Butyl-maleinimid enthaltende Polymere, die beim erfindungsgemäßen Verfahren eingesetzt werden können, sind Gegenstand der deutschen Patentanmeldung Akt.Z. P 40 40 996.1 (GR 90 P 8597 DE) - "Maleinimid-Polymere". Die Polymere können dabei sowohl als Bipolymere als auch als Terpolymere aufgebaut sein.

Als Photoinitiator, der im vorliegenden Fall auch als Photosäure bezeichnet wird, können beim erfindungsgemäßen Verfahren an sich bekannte Verbindungen dienen (siehe dazu beispielsweise EP-OS 0 102 450 und 0 234 327). Wichtig für die Auswahl des Photoinitiators ist allein die geforderte Eigenschaft, bei Belichtung eine Säure freizusetzen. Die Belichtung erfolgt dabei mit UV-Licht oder mit Elektronen- bzw. Röntgenstrahlen, wobei vorteilhaft eine starke Säure gebildet wird. Die Säure bewirkt dann eine Abspaltung des tert.-Butoxycarbonyl- bzw. tert.-Butylrestes von den blockierten Imidgruppen, und zwar bei einer der Belichtung folgenden Temperaturbehandlung. Durch diese säurekatalysierte Entblockierung wird das zunächst hydrophobe, kaliunlösliche Polymer hydrophil und alkalilöslich.

Beim erfindungsgemäßen Verfahren ist der Photoinitiator vorzugsweise ein Oniumsalz. Derartige Verbindungen, die auch als Crivellosalze bezeichnet werden, sind beispielsweise Diphenyljodonium- und Triphenylsulfonium-triflat (mit Triflat wird der Trifluormethansulfonylrest bezeichnet). Weitere einsetzbare Photoinitiatoren sind beispielsweise Triazinderivate. Der Photoinitiator wird im allgemeinen in einer Konzentration von 1 bis 20 Masse-% eingesetzt, bezogen auf den trockenen Photoresist, d.h. die lösungsmittelfreie Resistzusammensetzung.

Als Lösungsmittel dienen an sich bekannte Resistlösungsmittel. Wichtig für die Auswahl des Lösungsmittels ist allein das Erfordernis, daß sowohl die Polymerkomponente als auch der Photoinitiator gelöst werden muß. Außerdem müssen - mit den bekannten Beschichtungsverfahren - fehlerfreie Resistschichten auf den Substraten gebildet werden, beispielsweise auf Siliciumwafern oder auf mit einem Bottomresist beschichteten Wafern. Vorzugsweise ist das Lösungsmittel Cyclohexanon oder Methoxypropylacetat, daneben gelangt beispielsweise auch Diethylenglykoldimethylether zum Einsatz.

Der beim erfindungsgemäßen Verfahren eingesetzte Photoresist weist eine Empfindlichkeit von 1 bis 5 mJ/cm² auf. Neben den genannten Komponenten kann dieser Photoresist auch weitere Zusätze enthalten. Derartige Zusätze sind beispielsweise Sensibilisatoren, durch welche der Resist für Belichtungen im nahen UV-Bereich sensibilisiert werden kann, beispielsweise bei 365 nm. Ein geeigneter Sensibilisator ist dabei insbesondere Perylen.

Nach dem erfindungsgemäßen Verfahren können sowohl positive als auch negative Strukturen erzeugt werden, und zwar je nachdem, ob bei der Naßentwicklung ein Entwickler verwendet wird, welcher die belichteten, d.h. die hydrophilen und alkalilöslichen Bereiche (der bildmäßig belichteten Photoresistschicht) herauslöst, oder ein Entwickler, welcher die unbelichteten, d.h. die hydrophoben, alkaliunlöslichen Bereiche herauslöst. Dies ist im ersten Fall ein wäßrig-alkalischer Entwickler und im zweiten Fall ein organischer Entwickler, d.h. ein flüssiges organisches Medium, insbesondere in Form eines relativ hochsiedenden organischen Lösungsmittels, wie Anisol, Toluol und Xylol. Das findungsgemäße Verfahren kann ferner sowohl in der resisttechnik (mit Naßentwicklung) als auch in der Zweilagenresisttechnik (mit Naß- und Trockenentwicklung) eingesetzt werden.

Bei der Einlagentechnik finden vorzugsweise solche Polymere Verwendung, welche - neben tert.-Butoxycarbonyl- bzw. tert.-Butylgruppen und Carbonsäureanhydridgruppen - zusätzlich noch aromatische Gruppen aufweisen. Derartige Polymere können - in einfacher Weise - beispielsweise durch radikalische Polymerisation von Maleinsäureanhydrid und N-tert.-Butoxycarbonyl- bzw. N-tert.-Butyl-maleinimid mit einem aromatischen Monomer, wie Styrol, und gegebenenfalls mit einem oder mehreren weiteren Monomeren, wie Allyltrimethylsilan, erhalten werden. Es können aber auch andere aromatische Monomere eingesetzt werden, wie sie beispielsweise aus der EP-OS 0 388 484 bekannt sind. Dabei läßt sich - durch das Monomeren-Mischungsverhältnis - im Polymer sowohl der molare Anteil an tert.-Butoxycarbonyl- bzw. tert.-Butyl-maleinimid als auch derjenige an den anderen Monomeren leicht und reproduzierbar steuern. Für die Anwendung in der Einlagentechnik werden Terpolymere aus 10 bis 55 Mol-% tert.-Butoxycarbonyl- bzw. tert.-Butyl-maleinimid, 10 bis 55 Mol-% Maleinsäureanhydrid und 10 bis 55 Mol-% Styrol bevorzugt; die einzelnen Komponenten ergänzen sich dabei jeweils zu 100 %.

Bei der Zweilagentechnik finden vorzugsweise solche Polymere Verwendung, welche - neben tert.-Butoxycarbonyl- bzw. tert.-Butylgruppen und Carbonsäureanhydridgruppen - zusätzlich noch siliciumhaltige Gruppen aufweisen. Derartige Polymere können - in einfacher Weise - beispielsweise durch radikalische Polymerisation von Maleinsäureanhydrid und N-tert.-Butoxycarbonyl- bzw. N-tert.-Butyl-maleinimid mit einem siliciumhaltigen Monomer, wie Allyltrimethylsilan, und gegebenenfalls mit einem oder mehreren weiteren Monomeren, wie Styrol, erhalten werden. Es können aber auch andere siliciumhaltige Monomere eingesetzt werden, wie sie beispielsweise aus der EP-OS 0 388 484 bekannt sind. Dabei läßt sich - durch das Monomeren-Mischungsverhältnis - im Polymer sowohl der molare Anteil an tert.-Butoxycarbonyl- bzw. tert.-Butyl-maleinimid als auch derjenige an den anderen Monomeren leicht und reproduzierbar steuern. Für die Anwendung in der Zweilagentechnik werden Terpolymere aus 10 bis 55 Mol-% tert.-Butoxycarbonyl- bzw. tert.-Butyl-maleinimid, 10 bis 55 Mol-% Maleinsäureanhydrid und 10 bis 55 Mol-% Allyltrimethylsilan bevorzugt; die einzelnen Komponenten ergänzen sich dabei jeweils zu 100 %.

Das erfindungsgemäße Verfahren kann besonders vorteilhaft in der Weise zur Anwendung gelangen, wie es aus der EP-OS 0 395 917 bekannt ist, d.h. es kann zur Variation der Breite von Photoresiststrukturen dienen. Dies erfolgt zum einen bei der maßhaltigen Strukturübertragung in der Zweilagentechnik und zum anderen bei der Erzeugung von Strukturen jenseits der Auflösungsgrenze. Bei beiden Verfahrensweisen ist für die Auswahl des Resistpolymers wichtig, daß das Polymer anhydridhaltige Gruppen oder andere Gruppen aufweist, die spontan mit primären oder sekundären Aminen reagieren, insbesondere in Form von Aminosiloxanen.

Anhand von Ausführungsbeispielen soll die Erfindung noch näher erläutert werden.

### Beispiel 1

### Herstellung von Ter(N-tert.-Butoxycarbonyl-maleinimid/Maleinsäureanhydrid/Styrol)

Eine Lösung von 5,42 g N-tert.-Butoxycarbonyl-maleinimid (27,5 mmol), 2,7 g Maleinsäureanhydrid (27,5 mmol), 5,2 g Styrol (50 mmol) und 0,17 g Azoisobuttersäurenitril (1,04 mmol) in 50 ml Diethylketon wird unter einer Schutzgasatmosphäre 1 h zum Sieden erhitzt. Nach dem Abkühlen auf Raumtemperatur wird das dabei entstandene Terpolymer durch Eintropfen der Reaktionsmischung in 350 ml Petroleumbenzin ausgefällt. Nach Filtration und Trocknen im Vakuum werden 11,8 g farbloses aromatisches Polymer erhalten; ¹H-NMR-spektroskopisch wird im Terpolymer das Monomerverhältnis von ca. 1:1:2 bestätigt.

### Beispiel 2

### Herstellung von Ter(N-tert.-Butyl-maleinimid/Maleinsäureanhydrid/Styrol)

Eine Lösung von 4,21 g N-tert.-Butyl-maleinimid (27,5 mmol), 2,7 g Maleinsäureanhydrid (27,5 mmol), 5,2 g Styrol (50 mmol) und 0,17 g Azoisobuttersäurenitril (1,04 mmol) in 50 ml Diethylketon wird unter einer Schutzgasatmosphäre 1 h zum Sieden erhitzt. Nach dem Abkühlen auf Raumtemperatur wird das dabei entstandene Terpolymer durch Eintropfen der Reaktionsmischung in 350 ml Petroleumbenzin ausgefällt. Nach Filtration und Trocknen im Vakuum werden 11,5 g farbloses aromatisches Polymer erhalten; ¹H-NMR-spektroskopisch wird im Terpolymer das Monomerverhältnis von ca. 1:1:2 bestätigt.

### Beispiel 3

### Herstellung von Ter(N-tert.-Butoxycarbonyl-maleinimid/Maleinsäureanhydrid/Allyltrimethylsilan)

Eine Lösung von 4,34 g N-tert.-Butoxycarbonyl-maleinimid (22 mmol), 3,24 g Maleinsäureanhydrid (33 mmol), 5,71 g Allyltrimethylsilan (50 mmol) und 0,17 g Azoisobuttersäurenitril (1,04 mol) in 50 ml Diethylketon wird unter einer Schutzgasatmosphäre 1 h zum Sieden erhitzt. Nach dem Abkühlen auf Raumtemperatur wird das dabei entstandene Terpolymer durch Eintropfen der Reaktionsmischung in 350 ml Petroleumbenzin ausgefällt. Nach Filtration und Trocknen im Vakuum werden 10,2 g farbloses siliciumhaltiges Polymer erhalten; ¹H-NHR-spektroskopisch wird im Terpolymer das Monomerverhältnis von ca. 2:3:4,5 bestätigt.

### Beispiel 4

### Herstellung von Ter(N-tert.-Butyl-maleinimid/Maleinsäureanhydrid/Allyltrimethylsilan)

Eine Lösung von 3,37 g N-tert.-Butyl-maleinimid (22 mmol), 3,24 g Maleinsäureanhydrid (33 mmol), 5,71 g Allyltrimethylsilan (50 mmol) und 0,17 g Azoisobuttersäurenitril (1,04 mmol) in 50 ml Diethylketon wird unter einer Schutzgasatmosphäre 1 h zum Sieden erhitzt. Nach dem Abkühlen auf Raumtemperatur wird das dabei entstandene Terpolymer durch Eintropfen der Reaktionsmischung in 350 ml Petroleumbenzin ausgefällt. Nach Filtration und Trocknen im Vakuum werden 11,7 g farbloses siliciumhaltiges Polymer erhalten; ¹H-NMR-spektroskopisch wird im Terpolymer das Monomerverhältnis von ca. 2:3:4,5 bestätigt.

### Beispiel 5

### Herstellung von Quater(N-tert.-Butoxycarbonyl-maleinimid/Maleinsäureanhydrid/Allyltrimethylsilan/Styrol)

Eine Lösung von 4,34 g N-tert.-Butoxycarbonyl-maleinimid (22 mmol), 3,24 g Maleinsäureanhydrid (33 mmol), 2,86 g Allyltrimethylsilan (25 mmol), 2,61 g Styrol (25 mmol) und 0,17 g Azoisobuttersäurenitril (1,04 mmol) in 50 ml Diethylketon wird unter einer Schutzgasatmosphäre 1 h zum Sieden erhitzt. Nach dem Abkühlen auf Raumtemperatur wird das dabei entstandene Quaterpolymer durch Eintropfen der Reaktionsmischung in 350 ml Petroleumbenzin ausgefällt. Nach Filtration und Trocknen im Vakuum werden 10,8 g farbloses aromatisches, siliciumhaltiges Polymer erhalten; ¹H-NMR-spektroskopisch wird im Quaterpolymer das Monomerverhältnis von ca. 2:3:2:2 bestätigt.

### Beispiel 6

### Photoresist mit Ter(N-tert.-Butoxycarbonyl-maleinimid/Maleinsäureanhydrid/Styrol) und Diphenyljodonium-triflat

4,5 g des nach Beispiel 1 hergestellten Terpolymers werden bei Raumtemperatur zusammen mit 0,5 g Diphenyljodonium-triflat in 40 ml Cyclohexanon gelöst. Die Lösung wird dann bei 1800 rpm auf einen 4''-Siliciumwafer aufgeschleudert und bei 80°C 1 min auf einer Hotplate getrocknet. Dabei wird eine Resistschicht mit einer Dicke von 1 µm erhalten.

### Beispiel 7

### Photoresist mit Ter(N-tert.-Butyl-maleinimid/Maleinsäureanhydrid/Styrol) und Diphenyljodonium-triflat

4,5 g des nach Beispiel 2 hergestellten Terpolymers werden bei Raumtemperatur zusammen mit 0,5 g Diphenyljodonium-triflat in 40 ml Cyclohexanon gelöst. Die Lösung wird dann bei 2000 rpm auf einen 4''-Siliciumwafer aufgeschleudert und bei 80°C 1 min auf einer Hotplate getrocknet. Dabei wird eine Resistschicht mit einer Dicke von 1 µm erhalten.

### Beispiel 8

### Photoresist mit Ter(N-tert.-Butyl-maleinimid/Maleinsäureanhydrid/Allyltrimethylsilan) und Diphenyljodonium-triflat

4,5 g des nach Beispiel 4 hergestellten Terpolymers werden bei Raumtemperatur zusammen mit 0,5 g Diphenyljodonium-triflat in 40 ml Cyclohexanon gelöst. Die Lösung wird dann bei 3500 rpm auf einen 4"-Siliciumwafer, der zuvor mit einer 1,3 µm dicken Bottomresistschicht (bei 230°C ausgeheizter Novolakresist) versehen wurde, aufgeschleudert und bei 80°C 1 min auf einer Hotplate getrocknet. Dabei wird eine Resistschicht mit einer Dicke von 0,32 µm erhalten.

Wird für 1 min bei 140°C getrocknet, so wird eine Resistschicht mit einer Dicke von 0,3 µm erhalten.

### Beispiel 9

### Photoresist mit Quater(N-tert.-Butoxycarbonyl-maleinimid/Maleinsäureanhydrid/Allyltrimethylsilan/Styrol) und Diphenyljodonium-triflat

4,5 g des nach Beispiel 5 hergestellten Quaterpolymers werden bei Raumtemperatur zusammen mit 0,5 g Diphenyljodonium-triflat in 40 ml Cyclohexanon gelöst. Die Lösung wird dann bei 4000 rpm auf einen 4"-Siliciumwafer, der zuvor mit einer 1,3 µm dicken Bottomresistschicht (bei 230°C ausgeheizter Novolakresist) versehen wurde, aufgeschleudert und bei 80°C 1 min auf einer Hotplate getrocknet. Dabei wird eine Resistschicht mit einer Dicke von 0,32 µm erhalten.

Wird für 1 min bei 140°C getrocknet, so wird eine Resistschicht mit einer Dicke von 0,3 µm erhalten.

### Beispiel 10

### Messung der DUV-Photoempfindlichkeit und des Kontrastes

Eine nach Beispiel 6 hergestellte Einlagenresistschicht wird bei 248 nm durch eine Graukeilmaske (Fa. Ditric Optics-Wilm. Div.) kontaktbelichtet. Nach der Belichtung wird der Wafer 1 min auf eine 110°C heiße Hotplate gelegt und anschließend 120 s im kommerziellen Entwickler NMD-W 2,38 % (Fa. Tokyo Ohka) entwickelt. Der entwickelte Wafer wird dann unter fließendem Wasser gespült und bei 100°C 1 min auf einer Hotplate getrocknet. Der kontaktbelichtete Wafer zeigt eine Empfindlichkeit von 1,9 mJ/cm² und einen sehr hohen Kontrast von -γ > 6. Die feinsten Strukturen auf der Maske, 1 µm-Stege und -Gräben, werden exakt aufgelöst. Ein Schichtabtrag an den unbelichteten Stellen wird nicht festgestellt.

Ein kontaktbelichteter, thermisch bei 120°C behandelter Wafer mit einer nach Beispiel 7 hergestellten Einlagenresistschicht zeigt eine Empfindlichkeit von 1,3 mJ/cm² und einen sehr hohen Kontrast von -γ > 5. Die feinsten Strukturen auf der Maske werden auch hierbei exakt aufgelöst; ein Schichtabtrag an den unbelichteten Stellen erfolgt nicht.

### Beispiel 11

### DUV-Photostrukturierung

Eine nach Beispiel 6 hergestellte Einlagenresistschicht wird auf einem KrF-Excimerlaser-Projektionsbelichtungsgerät (Belichtungswellenlänge: 248 nm; numerische Apertur: 0,37; sungsvermögen: 0,35 µm) mit einer Dosis von 18 mJ/cm² bildmäßig belichtet. Nach der Belichtung wird der Wafer 1 min auf eine 110°C heiße Hotplate gelegt und anschließend 120 s im kommerziellen Entwickler NMD-W 2,38 % (Fa. Tokyo Ohka) entwickelt. Der entwickelte Wafer wird dann unter fließendem Wasser gespült und bei 100°C 1 min auf einer Hotplate getrocknet. Strukturen mit steilen Flanken können bis zu 0,35 µm gut aufgelöst werden.

Bei einem mit 10 mJ/cm² bildmäßig belichteten, thermisch bei 120°C behandelten Wafer mit einer nach Beispiel 7 hergestellten Einlagenresistschicht können ebenfalls Strukturen mit steilen Flanken bis zu 0,35 µm gut aufgelöst werden.

### Beispiel 12

### Messung der DUV-Photoempfindlichkeit und des Kontrastes

Eine nach Beispiel 9 hergestellte Zweilagenresistschicht wird bei 248 nm durch eine Graukeilmaske (Fa. Ditric Optics-Wilm. Div.) kontaktbelichtet. Nach der Belichtung wird der Wafer 1 min auf eine 110°C heiße Hotplate gelegt und anschließend 90 s im kommerziellen Entwickler NMD-W 2,38 % (Fa. Tokyo Ohka) entwickelt. Der entwickelte Wafer wird dann unter fließendem Wasser gespült und bei 100°C 1 min auf einer Hotplate getrocknet. Der kontaktbelichtete Wafer zeigt eine Empfindlichkeit von 1,7 mJ/cm² und einen sehr hohen Kontrast von -γ > 7. Die feinsten Strukturen auf der Maske, 1 µm-Stege und -Gräben, werden exakt aufgelöst. Bei einer vorausgegangenen Trocknung der Resistschicht (siehe Beispiel 9) bei 80°C wird in den unbelichteten Bereichen kein Schichtabtrag festgestellt. Im Falle einer Trocknung bei 140°C beträgt der Schichtabtrag an den unbelichteten Stellen 40 nm.

Ein kontaktbelichteter, thermisch bei 120°C behandelter Wafer mit einer nach Beispiel 8 hergestellten Zweilagenresistschicht zeigt eine Empfindlichkeit von 1,1 mJ/cm² und einen sehr hohen Kontrast von -γ > 6. Die feinsten Strukturen auf der Maske werden auch hierbei exakt aufgelöst. Bei einer vorausgegangenen Trocknung der Resistschicht (siehe Beispiel 8) bei 80°C wird in den unbelichteten Bereichen kein Schichtabtrag festgestellt. Im Falle einer Trocknung bei 140°C beträgt der Schichtabtrag an den unbelichteten Stellen 35 nm.

### Beispiel 13

### DUV-Photostrukturierung

Eine nach Beispiel 9 hergestellte Zweilagenresistschicht (bei 80°C getrocknet) wird auf einem KrF-Excimerlaser-Projektionsbelichtungsgerät (Belichtungswellenlänge: 248 nm; numerische Apertur: 0,37; Auflösungsvermögen: 0,35 µm) mit einer Dosis von 12 mJ/cm² bildmäßig belichtet. Nach der Belichtung wird der Wafer 1 min auf eine 110°C heiße Hotplate gelegt und anschließend 90 s im kommerziellen Entwickler NMD-W 2,38 % (Fa. Tokyo Ohka) entwickelt. Der entwickelte Wafer wird dann unter fließendem Wasser gespült und bei 100°C 1 min auf einer Hotplate getrocknet. Strukturen mit steilen Flanken können bis zu 0,25 µm gut aufgelöst werden.

Bei einem mit 8 mJ/cm² bildmäßig belichteten, thermisch bei 120°C behandelten Wafer mit einer nach Beispiel 8 hergestellten Zweilagenresistschicht (bei 80°C getrocknet) können ebenfalls Strukturen mit steilen Flanken bis zu 0,25 µm gut aufgelöst werden.

### Beispiel 14

### Maßhaltige Abbildung von Maskenstrukturen (im Bottomresist)

Eine nach Beispiel 9 hergestellte Zweilagenresistschicht wird - entsprechend Beispiel 13 - mit einer Dosis von 18 mJ/cm² bildmäßig belichtet, thermisch behandelt (110°C), entwickelt und getrocknet. Dabei werden Resiststrukturen (Stege) erhalten, die um 0,1 µm schmaler sind als das entsprechende Maskenmaß. Diese Strukturen werden 60 s mit einem siliciumhaltigen Agens, bestehend aus 8 MT eines oligomeren linearen Dimethylsiloxans mit endständigen Aminopropylgruppen, 86 MT 1-Methoxy-2-propanol und 6 MT Wasser (MT = Masseteile), behandelt, dann wird mit Isopropanol gespült und getrocknet. Dabei werden Resiststrukturen erhalten, die um 0,03 µm breiter sind als das entsprechende Maskenmaß. Wird der Wafer nachfolgend in einem Plasmareaktor mit einem Sauerstoffplasma geätzt (Gasdruck: 6 mTorr; Biasspannung: 410 V), so werden Bottomresiststrukturen mit dem exakten Maskenmaß und senkrechten Flanken erhalten. Bei einer vorausgegangenen Trocknung der Resistschicht (siehe Beispiel 9) bei 80°C können somit Strukturen bis 0,45 µm, im Falle einer Trocknung bei 140°C Strukturen bis 0,25 µm maßhaltig aufgelöst werden.

Bei einem mit 11 mJ/cm² bildmäßig belichteten, thermisch bei 120°C behandelten Wafer mit einer nach Beispiel 8 hergestellten Zweilagenresistschicht können - nach einer Behandlung mit dem siliciumhaltigen Agens für die Dauer von 40 s - ebenfalls Strukturen bis 0,45 µm bzw. 0,25 µm maßhaltig aufgelöst werden.

### Beispiel 15

### Erzeugung schmaler Resistgräben

Eine nach Beispiel 9 hergestellte Zweilagenresistschicht (bei 140°C getrocknet) wird - entsprechend Beispiel 13 - bildmäßig belichtet (Dosis: 12 mJ/cm²), thermisch behandelt (110°C), entwickelt und getrocknet. Die dabei erhaltenen Resiststrukturen zeigen das exakte entsprechende Maskenmaß. Diese Strukturen werden 120 s mit dem siliciumhaltigen Agens entsprechend Beispiel 14 behandelt, dann wird mit Isopropanol gespült und getrocknet. Dabei werden Resistgräben erhalten, die um 0,28 µm schmaler sind als das entsprechende Maskenmaß. Wird der Wafer nachfolgend in einem Plasmareaktor mit einem Sauerstoffplasma geätzt (Gasdruck: 6 mTorr; Biasspannung: 410 V), so werden Bottomresistgräben mit senkrechten Flanken erhalten, die um 0,25 µm schmaler sind als das entsprechende Maskenmaß. So wird beispielsweise aus einem Graben mit einem Maskenmaß von 0,35 µm ein Bottomresistgraben mit einer Weite von 0,1 µm erhalten, d.h. es werden Strukturen weit unterhalb der Auflösungsgrenze der angewendeten Belichtungstechnik erhalten.

Bei einem mit 8 mJ/cm² bildmäßig belichteten, thermisch bei 120°C behandelten Wafer mit einer nach Beispiel 8 hergestellten Zweilagenresistschicht (bei 140°C getrocknet) werden - nach einer Behandlung mit dem siliciumhaltigen Agens für die Dauer von 100 s - entsprechende Strukturen erhalten.

### Beispiel 16

In analoger Weise wie in den Beispielen 14 und 15 für Zweilagenresistschichten beschrieben, kann - unter Verwendung eines aromatenhaltigen, d.h. siliciumfreien Agens - bei Einlagenresistschichten verfahren werden; dazu wird dann entsprechend Beispiel 11 vorgegangen. Ein geeignetes aromatenhaltiges Agens, das - ebenso wie das siliciumhaltige Agens - Aminogruppen aufweist, besteht beispielsweise aus 10 MT 1,3-Diaminomethylbenzol, 86 MT 1-Methoxy-2-propanol und 6 MT Wasser (MT = Masseteile). Die Herstellung der Einlagenresistschicht kann beispielsweise entsprechend Beispiel 8 erfolgen, d.h. unter Verwendung von Ter(N-tert.-Butyl-maleinimid/Maleinsäureanhydrid/Allyltrimethylsilan). In entsprechender Weise kann aber auch Ter(N-tert.-Butoxycarbonyl-maleinimid/Maleinsäureanhydrid/Allyltrimethylsilan) eingesetzt werden (siehe Beispiel 3).

## Patentansprüche

1. Verfahren zur Strukturerzeugung im Submikron-Bereich,
**dadurch gekennzeichnet,** daß
a) auf ein Substrat eine Photoresistschicht aus einer Polymerkomponente mit
- funktionellen Gruppen, die zu einer Reaktion mit primären oder sekundären Aminen befähigt sind, und
- N-blockierten Imidgruppen,
einem bei Belichtung eine Säure freisetzenden Photoinitiator und einem geeigneten Lösungsmittel aufgebracht wird,
b) die Photoresistschicht getrocknet wird,
c) die Photoresistschicht bildmäßig belichtet wird,
d) die belichtete Photoresistschicht einer Temperaturbehandlung unterworfen wird,
e) die derart behandelte Photoresistschicht mit einem wäßrigalkalischen oder organischen Entwickler zu einer Photoresiststruktur entwickelt wird und
f) die Photoresiststruktur - zur Aufweitung der Resistlinien und zur Erzeugung von Ätzresistenz - mit einem ein primäres oder sekundäres Amin enthaltenden chemischen Agens behandelt wird,
wobei bei der Entwicklung ein definierter Dunkelabtrag im Bereich zwischen 20 und 100 nm eingestellt wird.

2. Verfahren nach Anspruch 1, **dadurch gekennzeichnet,** daß auf das Substrat zunächst eine gegen Substratätzprozesse resistente Resistschicht aufgebracht und ausgeheizt wird, und daß die Photoresiststruktur nach der Behandlung mit dem chemischen Agens (Schritt f) in einem anisotropen sauerstoffhaltigen Plasma geätzt wird.

3. Verfahren nach Anspruch 1 oder 2, **dadurch gekennzeichnet**, daß der definierte Dunkelabtrag durch eine Temperatur/Zeit-Kombination bei der Trocknung (Schritt b) und/oder bei der Temperaturbehandlung (Schritt a) und/oder durch Temperatur und Dauer der Entwicklung sowie Art und gegebenenfalls Konzentration des Entwicklers (Schritt e) eingestellt wird.

4. Verfahren nach einem der Ansprüche 1 bis 3, **dadurch gekennzeichnet,** daß eine Polymerkomponente mit Carbonsäureanhydridgruppen (als funktionelle Gruppen) eingesetzt wird.

5. Verfahren nach Anspruch 4, **dadurch gekennzeichnet**, daß den Carbonsäureanhydridgruppen Maleinsäureanhydrid zugrunde liegt.

6. Verfahren nach einem oder mehreren der Ansprüche 1 bis 5_{,} **dadurch gekennzeichnet,** daß eine Polymerkomponente mit durch einen tert.-Butoxycarbonylrest blokkierten Imidgruppen eingesetzt wird.

7. Verfahren nach einem oder mehreren der Ansprüche 1 bis 5, **dadurch gekennzeichnet**, daß eine Polymerkomponente mit durch einen tert.-Butylrest blockierten Imidgruppen eingesetzt wird.

8. Verfahren nach Anspruch 6 oder 7, **dadurch gekennzeichnet,** daß den Imidgruppen Maleinimid zugrunde liegt.

9. Verfahren nach einem der Ansprüche 4 bis 8, **dadurch gekennzeichnet,** daß ein N N-tert.-Butoxycarbonyl-bzw. N-tert.-Butyl-maleinimid/Maleinsäureanhydrid-Copolymer verwendet wird.

10. Verfahren nach einem der Ansprüche 4 bis 8, **dadurch gekennzeichnet**, daß ein N N-tert.-Butoxycarbonylbzw. N-tert.-Butyl-maleinimid, Maleinsäureanhydrid und Styrol und/oder Allyltrimethylsilan enthaltendes Copolymer verwendet wird.

## Claims

1. A process for producing structures in the submicron range characterised by the steps of:
a) depositing on to a substrate a photoresist layer comprising
- a polymer constituent having functional groups which are capable of reacting with primary or secondary amines, and N-blocked imide groups
- a photoinitiator which liberates an acid when irradiated, and
- a suitable solvent;
b) drying the photoresist layer;
c) exposing the photoresist layer in an patternwise manner;
d) subjecting the exposed photoresist layer to a heat treatment;
e) developing the photoresist layer, treated in this manner, with an aqueous-alkaline or organic developing agent to create a photoresist structure; and
f) treating the photoresist structure with a chemical agent containing a primary or secondary amine, so as to widen the resist lines and to produce etching resistance,
with the dark field loss during the development being defined and adjusted to be in the range of between 20 and 100 nm.

2. The process according to claim 1, characterised in that a resist layer which is resistant to substrate etching processes is initially applied to the substrate and is baked out, and that the photoresist structure, after the treatment with the chemical agent (step f), is etched in an anisotropic, oxygen-containing plasma.

3. The process according to claim 1 or claim 2, characterised in that the defined dark loss is adjusted by a temperature/time combination during the drying (step b) and/or during the heat treatment (step d) and/or by the temperature and duration of the development and the nature and possibly the concentration of the developer (step e).

4. The process according to one of claims 1 to 3, characterised in that a polymer constituent having carboxylic acid anhydride groups (as the functional groups) is used.

5. The process according to claim 4, characterised in that the basis of the carboxylic acid anhydride groups is maleic anhydride.

6. The process according to one or more of claims 1 to 5, characterised in that a polymer constituent having imide groups blocked by a tertiary butoxycarbonyl residue is used.

7. The process according to one or more of claims 1 to 5, characterised in that a polymer constituent having imide groups blocked by a tertiary butyl residue is used.

8. The process according to claim 6 or claim 7, characterised in that the basis of the imide groups is maleimide.

9. The process according to any one of claims 4 to 8, characterised in that an N-tertiary butoxycarbonyl- or N-tertiary butyl-maleimide/maleic anhydride copolymer is used.

10. The process according to any one of claims 4 to 8, characterised in that a copolymer containing N-tertiary butoxycarbonyl- or N-tertiary butyl-maleimide, maleic anhydride and styrene and/or allyl trimethylsilane is used.

## Revendications

1. Procédé pour la structuration dans le domaine du sous-micron, caractérisé en ce que
a) on applique sur un substrat une couche d'une photoréserve constituée par un composant polymère comprenant
- des groupes fonctionnels qui sont à même de réagir avec des amines primaires ou secondaires, et
- des groupes imides bloqués sur l'atome d'azote,
par un photoinitiateur libérant un acide lorsqu'il est exposé et par un solvant approprié,
b) on sèche la couche de la photoréserve,
c) on expose photographiquement la couche de la photoréserve,
d) on soumet la couche de la photoréserve exposée à un traitement thermique,
e) on développe la couche de la photoréserve traitée ce cette manière, avec un révélateur aqueux-alcalin ou organique pour obtenir une structure de la photoréserve, et
f) on traite la structure de la photoréserve - pour élargir les lignes de réserve et pour obtenir une résistance à la gravure - avec un agent chimique contenant une amine primaire ou secondaire,
dans lequel, lors du développement, on règle une décroissance définie à l'obscurité dans le domaine entre 20 et 100 nm.

2. Dispositif selon la revendication 1, caractérisé en ce qu'on applique sur le substrat d'abord une couche de réserve qui résiste aux processus de gravure du substrat et on la chauffe, et en ce qu'on soumet la structure de la photoréserve après le traitement avec l'agent chimique (étape f) à une gravure dans un plasma oxygéné anisotrope.

3. Procédé selon la revendication 1 ou 2, caractérisé en ce qu'on règle la décroissance définie à l'obscurité via une combinaison de température/temps lors du séchage (étape b) et/ou lors du traitement thermique (étape d) et/ou par la température et la durée du développement, ainsi que par le type et éventuellement par la concentration du révélateur (étape e).

4. Procédé selon l'une quelconque des revendications 1 à 3, caractérisé en ce qu'on met en oeuvre un composant polymère contenant des groupes d'anhydrides carboxyliques (comme groupes fonctionnels).

5. Procédé selon la revendication 4, caractérisé en ce que l'anhydride maléique sert de base aux groupes d'anhydrides carboxyliques.

6. Procédé selon l'une ou plusieurs des revendications 1 à 5, caractérisé en ce qu'on met en oeuvre un composant polymère contenant des groupes imides bloqués par un radical tert.-butoxycarbonyle.

7. Procédé selon l'une ou plusieurs des revendications 1 à 5, caractérisé en ce qu'on met en oeuvre un composant polymère contenant des groupes imides bloqués par un radical tert.-butyle.

8. Procédé selon la revendication 6 ou 7, caractérisé en ce que le maléimide sert de base aux groupes imides.

9. Procédé selon l'une quelconque des revendications 4 à 8, caractérisé en ce qu'on utilise un copolymère de N-tert.-butoxycarbonyle, respectivement N-tert.-butylmaléimide/anhydride maléique.

10. Procédé selon l'une quelconque des revendications 4 à 8, caractérisé en ce qu'on utilise un copolymère contenant du N-tert.-butoxycarbonyle, respectivement N-tert.-butylmaléimide, de l'anhydride maléique et du styrène et/ou de l'allyltriméthylsilane.
